# EUROPEAN PATENT APPLICATION

(11) **EP 4 572 109 A1**
(43) Date of publication of application: **18.06.2025**
(21) Application number: 23774071.7
(22) Date of filing: 23.03.2023
(51) Int. Cl.: H02K 53/00

(54) **AUTONOMOUS PORTABLE POWER GENERATOR DEVICE**

(30) Priority: 23.03.2022 ES 202230485 U
(71) Applicant: MG Innovacion y Tecnologia, S.L., 46022 Valencia (ES); Intransval 3, S.L., 46022 Valencia (ES)
(72) Inventor: GADEA CERDEÑA, Mario, 46022 Valencia (ES); ALAMAR LLAVATA, Jose Manuel, 46022 Valencia (ES)
(74) Representative: Santarelli
(86) International application number: PCT/ES2023/070188
(87) International publication number: WO 2023/180616

(57) **Abstract**

Disclosed is a completely autonomous portable power generator device for generating free power, which comprises a motor, a generator or alternator, an uninterruptable power supply (UPS) source, a pair of transformers, an inverter and a switch, wherein, once the device is activated by means of the UPS power source, the motor is powered by the first transformer (8), the motor moving the alternator, which generates a current that passes to a second transformer and subsequently to the inverter to power both the outlet of sockets and USB ports, and the UPS power system itself, all the elements being contained in a suitcase-type casing with handles and wheels.

## Description

### OBJECT OF THE INVENTION

The present invention relates to a completely autonomous generator of free and transportable energy, as if it were a suitcase or travel trolley, from a modified alternator.

It comes to propose a solution to the problem of taking energy from one place to another, without the need to connect to any network, since it is totally independent and autonomous, and to the generation of continuous and totally clean electricity without affecting the environment.

The equipment is mainly composed of a set of motor, alternator, inverter, switch and transformer, together with a UPS power supply, with the whole set being inside a "trolley" type container housing with wheels.

The industrial application of this invention lies within the field of generating equipment and devices, and more specifically, independent and autonomous current generators to supply free energy for private use both caravans, vehicles, boats and homes.

### BACKGROUND TO THE INVENTION

Although no invention identical to the one described has been found, we present below the documents found that reflect the state of the art related to it.

Thus, the document ES2400524U refers to a mobile platform for the intelligent charging of electric vehicles, characterised by the fact that it includes at least one Authorised Point of connection to the electricity grid consisting of a point identified within the Supply Company, linked to a contract, and physically located on a standardised, conventional or MOVELE current basis, and at least one piece of equipment or mobile suitcase equipped with electronic elements to connect between said authorised point and the vehicle. This utility model refers, therefore, to a mobile platform but which needs connection to the electricity network, so it does not offer the autonomy and independence of the portable device that is the subject of the invention applied for.

ES107654U describes a stand-alone and portable solar power equipment that, being of the type that provides electrical power from photovoltaic modules, is applicable to work as a stand-alone system in places without a power grid; as a complementary system in installations with a connection to the network; and as an emergency system due to failure of the power grid, being characterized by the fact that, housed in a portable case, it comprises: - several photovoltaic module units, - a bypass contactor switch, to discriminate the solar input to a regulator or an inverter, - a solar charge regulator, - a converter, - storage batteries, - a grid inverter, - a battery charger, as well as the rest of the elements that allow their operation to convert the solar energy captured by these photovoltaic modules into electrical energy. Therefore, despite being an autonomous and portable equipment for the assistance of electrical energy in places without an electrical network such as the one proposed by the invention applied for, it uses photovoltaic modules for energy capture, which are not required in the portable device that is the subject of this application.

ES2392423A1 refers to a foldable solar collector to generate electrical energy, which, being designed to convert solar energy or artificial light into electrical energy, using photovoltaic cells materialized in silicon, polycrystalline or monocrystalline material, or others, is characterized by being made up of a plurality of panels carrying the corresponding photovoltaic cells in correspondence with one of the ends, while the other end of these panels are commonly linked in an articulated way to a rotating cylinder head that in combination with a pivot makes it possible to fold and unfold the panels on top of each other, and therefore of the photovoltaic cells in the position of use or in the inoperative position; It has been foreseen that through the pivot the whole is related to a support base consisting of a tripod with adjustable legs for its stabilization in any place or surface of land, both regular and irregular. Like the previous document, it is characterized by the use of photovoltaic cells to convert solar energy into electrical energy, so it does not affect the novelty or inventive step of the main invention.

Conclusions: As can be seen from the research carried out, none of the documents found solves the problems raised as the proposed invention does.

### DESCRIPTION OF THE INVENTION

The portable autonomous current generating device that is the subject of the present invention is made up of electromechanical equipment, contained within a trolley-type container housing with wheels, and divided into two parts, upper and lower, clearly distinguishable: in the lower part there is a chassis where an electric motor is installed, a modified truck alternator (both in volts and in watts) and a timing belt system, and at the top are the UPS power supply, a first transformer from 220V to 7A, an inverter, a switch, and a second transformer from 220V to 12V.

In addition to these elements, the device has feedback elements and accessories, cooling fans, magnetothermal outlets and protection fuses for plugs and USB ports, as well as an emergency start-up and stop interface.

Once the circuit detects the optimal output of the generator, after starting the electric motor from the starter, the latter stops, and the energy now comes from the generator directly to the engine, feeding back into each other.

### BRIEF DESCRIPTION OF THE DRAWINGS

For a better understanding of this description, some drawings are attached that represent a preferential non-limiting realization of the present invention:

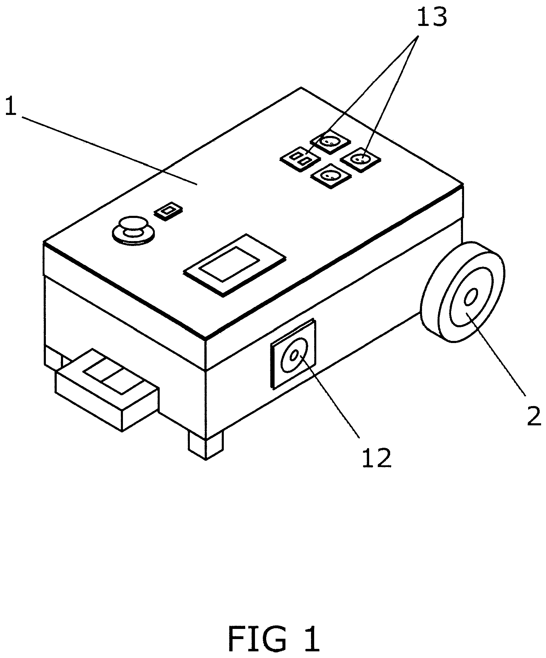

Figure 1: Conventional perspective view of the self-contained portable current-generating device that is the subject of the present invention.

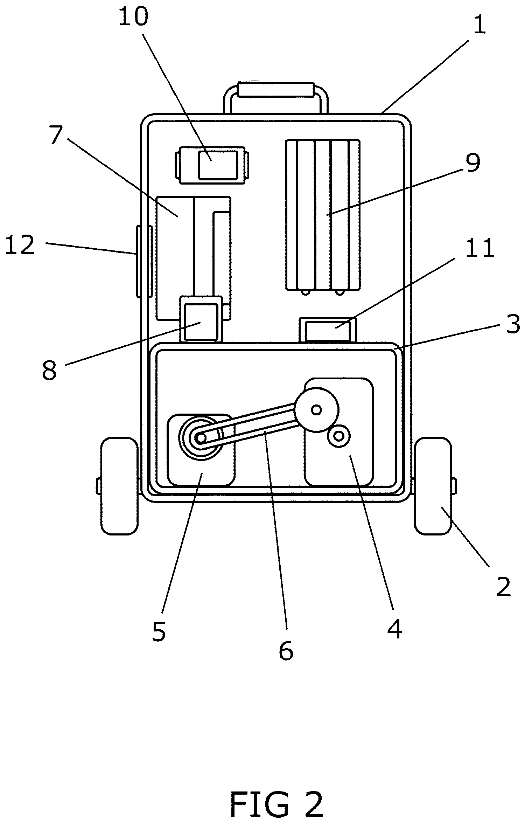

Figure 2: Interior view of the self-contained portable current-generating device that is the subject of the present invention.

The numerical references that appear in these figures correspond to the following constituent elements of the invention:
- 1.: Container housing
- 2.: Wheels
- 3.: Chassis
- 4.: Electric motor
- 5.: Alternator
- 6.: Pulleys and timing belt
- 7.: UPS Power Supply
- 8.: First transformer
- 9.: Investor
- 10.: Switch
- 11.: Second transformer
- 12.: Cooling fans
- 13.: Outlets with circuit breakers and protective fuses for sockets and USB ports

### DESCRIPTION OF A PREFERENTIAL REALIZATION

A preferential embodiment of the autonomous portable current-generating device which is the subject of the present invention, with reference to the numerical references, may be based on electromechanical equipment, contained within a container casing (1) of the trolley suitcase type with handle and wheels (2), and divided into two parts, upper and lower, clearly distinguishable: in the lower part there is a chassis (3) where a 12V and 250W electric motor is installed (4), a 220V and 1300W alternator (5) and a pulley and timing belt system (6) that connects them, and on top are the UPS power supply (7), a first transformer from 220V to 7A (8), a 15000W inverter (9), a 12V switch (10), and a second transformer from 220V to 12V (11).

In addition to these elements, the device has feedback elements and accessories to recharge the UPS power supply (7), cooling fans (12), outlets with circuit breakers and protection fuses for plugs and USB ports (13), as well as start-up (switch) and emergency stop interface (14).

When the device is started, the current from the UPS power supply (7), which comes out at 220V, passes to 12V, through the first transformer (8), to power the electric motor (4), which moves the alternator (5) through the pulley and timing belt system (6), and the current coming out of the alternator (5) is passed to the second transformer (11) and changed from 220V to 24V; then it goes to the inverter (9) and is taken out at 220V and about 6000w of output to the plugs and USB ports (13).

The current to recharge the UPS power supply (7) is also obtained from the inverter (9).

## Claims

1. Portable autonomous current generating device, consisting of an electromechanical equipment consisting of an electric motor (4), an alternator (5), a pulley system and timing belt (6) that connects them, a UPS power supply (7), a pair of transformers (8, 11), an inverter (9), a switch (10), feedback elements and accessories to recharge the UPS power supply (7), outputs with circuit breakers and protection fuses for plugs and USB ports (13), as well as a start-up (switch) and emergency stop interface (14), **characterised by** the fact that these elements and the chassis (1) where they are mounted is integrated into a container housing (1) trolley suitcase with handle and wheels (2), and divided into two parts, upper and lower, so that, by starting the device, the current from the UPS power supply (7) feeds, through the first transformer (8), to the electric motor (4), which moves the alternator (5) through the pulley and timing belt system (6), and the current coming out of the alternator (5) is passed to the second transformer (11) and then passes to the inverter (9) to supply both the output to the plugs and USB ports (13) as well as to the UPS power supply (7).

2. Portable autonomous current generating device, according to claim 1, where the container casing (1) of the "trolley" suitcase type includes cooling fans (12).

3. Portable autonomous current generating device, according to claim 1, where the alternator (5) is a truck-type alternator, modified to give an output of 220V and a power greater than 1300W.
